# EUROPEAN PATENT SPECIFICATION

(11) **EP 4 050 653 B1**
(45) Date of publication and mention of the grant of the patent: **31.01.2024**
(21) Application number: 21791241.9
(22) Date of filing: 30.06.2021
(51) Int. Cl.: H10B 12/00

(54) **METHOD FOR PREPARING SEMICONDUCTOR STRUCTURE, AND SEMICONDUCTOR STRUCTURE**
VERFAHREN ZUR HERSTELLUNG EINER HALBLEITERSTRUKTUR UND HALBLEITERSTRUKTUR
PROCÉDÉ DE PRÉPARATION DE STRUCTURE SEMI-CONDUCTRICE, ET STRUCTURE SEMI-CONDUCTRICE

(30) Priority: 30.12.2020 CN 202011630018
(43) Date of publication of application: 31.08.2022
(73) Proprietor: Changxin Memory Technologies, Inc., Hefei City, Anhui 230000 (CN)
(72) Inventor: BAI, Jie, Hefei City, Anhui 230000 (CN); YOU, Kang, Hefei City, Anhui 230000 (CN)
(74) Representative: Lavoix
(86) International application number: PCT/CN2021/103699
(87) International publication number: WO 2022/142225

(56) References cited:
- CN-A- 101 944 507
- CN-A- 108 538 839
- CN-A- 109 285 835
- US-A1- 2001 025 973
- US-A1- 2010 102 371
- US-A1- 2011 121 377
- US-A1- 2014 327 087
- US-A1- 2018 158 773
- US-A1- 2019 214 293

## Description

### CROSS-REFERENCE TO RELATED APPLICATION

This application claims priority to Chinese Patent Application No. 202011630018.1, entitled "METHOD FOR MANUFACTURING SEMICONDUCTOR STRUCTURE, AND SEMICONDUCTOR STRUCTURE" and filed to the State Intellectual Property Office on December 30, 2020.

### TECHNICAL FIELD

The present invention relates to the technical field of integrated circuit design and manufacturing, and more particularly, to a method for manufacturing a semiconductor structure and the semiconductor structure.

### BACKGROUND

With the rapid development of integrated circuit (IC) manufacturing processes, requirements for integration of semiconductor products are getting higher and higher. However, as the integration of the semiconductor products increases, sizes of semiconductor devices continue to decrease, which causes smaller and smaller gate sizes of peripheral circuits, more obvious short-channel effects, and higher probability of electric leakage.

A semiconductor memory device includes an array region and a peripheral region positioned at the periphery of the array region. The array region includes a cell region and a peripheral region positioned at the periphery of the cell region and configured for arranging various kinds of logic circuits. For example, the peripheral region configured for arranging various kinds of logic circuits may include a sense amplifier circuit, a switch control circuit, or a clock circuit, etc.

How to reduce the sizes of the semiconductor devices and ensure that the gate sizes of circuits in the peripheral region meet the requirements for circuit integration design while avoiding the increase of the short-channel effects and leakage current of the semiconductor devices has become one of technical problems to be solved urgently in the field of semiconductor manufacturing technologies.

US 2001/025973 A1 discloses that semiconductor integrated circuit device and process for manufacturing the same. US 2001/025973 discloses semiconductor memory devices having buried word lines in a memory cell region and buried gates in a peripheral circuit region.

### SUMMARY

According to the present invention, there is provided a method for manufacturing a semiconductor structure, according to claim 1, and a semiconductor structure, according to claim 4. Embodiments of the invention are presented in the dependent claims.

The present invention is defined in the claims. Any embodiment in the description that does not fall within the scope of the claims shall be regarded as an example for understanding the present invention.

In the method for manufacturing a semiconductor structure in the foregoing embodiments, a patterned mask layer is formed on a surface of the substrate including a cell region and a peripheral region positioned at a periphery of the cell region, and the patterned mask layer is internally provided with a first opening pattern and a second opening pattern. The first opening pattern is positioned in the cell region to define a shape and a location of a word line trench, and the second opening pattern is positioned in the peripheral region to define a shape and a location of a peripheral gate trench. Next, the substrate is etched based on the patterned mask layer to form the word line trench in the cell region, and synchronously the peripheral gate trench is formed in the peripheral region. Next, a buried word line is formed in the word line trench, and synchronously a buried gate is formed in the peripheral gate trench. In the present invention, a word line in the cell region and a gate in the peripheral region at the periphery of the cell region are subject to single exposure and manufactured synchronously, which reduces manufacturing costs compared with separately manufacturing the gate in the peripheral region where an additional photomask is required. In the present invention, the word line in the cell region and the gate in the peripheral region at the periphery of the cell region both have buried structures, such that it is ensured that the gate sizes of circuits in the peripheral region meet the requirements for circuit integration design while avoiding the increase of the short-channel effects and leakage current of the semiconductor devices.

In the semiconductor structure provided in the foregoing embodiment, the word line in the cell region and the gate in the peripheral region at the periphery of the cell region both have buried structures, such that it is ensured that the gate sizes of circuits in the peripheral region meet the requirements for circuit integration design while avoiding the increase of the short-channel effects and leakage current of the semiconductor devices.

### BRIEF DESCRIPTION OF THE DRAWINGS

To better describe and illustrate the embodiments and/or examples of those applications disclosed herein, one or more drawings may be referred to. The additional details or examples configured for describing the drawings should not be considered as limiting the scope of any of the disclosed applications, the currently described embodiments and/or examples, and the best mode of these applications currently understood.
FIG. 1 is a flowchart of a method for manufacturing a semiconductor structure according to an embodiment of the present invention.
FIG. 2 is a schematic top view of a semiconductor structure according to an embodiment of the present invention.
FIG. 3 is a schematic top view showing structures of portions corresponding to a cell region 101 and a peripheral region 102 in FIG. 2.
FIG. 4a is a schematic structural diagram showing sections captured along directions A-A', C-C' and E-E' in FIG. 3 for a structure obtained in the operation S2 of a method for manufacturing a semiconductor structure according to an embodiment of the present invention.
FIG. 4b is a schematic structural diagram showing sections captured along directions A-A', C-C' and E-E' in FIG. 3 for a structure obtained in the operation S6 of a method for manufacturing a semiconductor structure according to an embodiment of the present invention.
FIGS. 4c to 4i are schematic structural diagrams showing sections captured along directions A-A', C-C' and E-E' in FIG. 3 for a structure obtained in the operation S8 of a method for manufacturing a semiconductor structure according to an embodiment of the present invention.
FIG. 5a is a schematic structural diagram showing sections captured along directions A-A', C-C' and E-E' in FIG. 3 for the structure obtained in the operation S2 of a method for manufacturing a semiconductor structure according to another embodiment of the present invention.
FIG. 5b is a schematic structural diagram showing sections captured along directions A-A', C-C' and E-E' in FIG. 3 for the structure obtained in the operation S6 of a method for manufacturing a semiconductor structure according to another embodiment of the present invention.
FIGS. 5c to 5k are schematic structural diagrams showing sections captured along directions A-A', C-C' and E-E' in FIG. 3 for the structure obtained in the operation S8 of a method for manufacturing a semiconductor structure according to another embodiment of the present invention.

Reference numbers in the accompanying drawings:
substrate 100; cell region 101;
peripheral region 102; first peripheral sub-region 1021; second peripheral sub-region 1022;
bit line 11; word line 12;
first active region 104; second active region 106; first shallow trench isolation structure 110;
second shallow trench isolation structure 120; word line trench 15;
peripheral gate trench 16; first peripheral gate trench 161; second peripheral gate trench 162;
gate oxide material layer 171; gate oxide layer 17;
first work function material layer 181; first work function layer 18;
first conductive material layer 191; first conductive layer 19;
primary conductive material layer 201; primary conductive layer 20;
cover insulation material layer 301; cover insulation layer 30;
buried word line 50;
buried gate 60; first buried gate 61; and second buried gate 62.

### DETAILED DESCRIPTION

For ease of understanding the present invention, the present invention will be described more fully hereinafter with reference to the accompanying drawings. Some embodiments of the present invention are provided in the accompanying drawings. The present invention may, however, be embodied in many different forms and should not be limited to the embodiments set forth herein. Rather, these embodiments are provided so that the present invention will be more thorough and complete.

Unless otherwise defined, all technical and scientific terms employed herein have the same meaning as commonly understood by one of ordinary skill in the art to which the present invention belongs. The terms employed in the specification of the present invention are merely for the purpose of describing some embodiments and are not intended for limiting the present invention. As used herein, the term "and/or" includes any and all combinations of one or more of the associated listed items.

It should be understood that when an element or layer is referred to as being "on", "adjacent to", "connected to" or "coupled to" other elements or layers, it may be directly on, adjacent to, connected or coupled to the other elements or layers, or intervening elements or layers may be present. In contrast, when an element is referred to as being "directly on", "directly adjacent to", "directly connected to" or "directly coupled to" other elements or layers, there are no intervening elements or layers present. It should be understood that although the terms first, second, third, etc. may be employed to describe various elements, components, regions, layers and/or sections, these elements, components, regions, layers and/or sections should not be limited by these terms. These terms are only employed to distinguish one element, component, region, layer or section from another element, component, region, layer or section. Therefore, without departing from the teachings of the present invention, a first element, component, region, layer or section discussed below may be represented as a second element, component, region, layer or section.

Spatially relative terms such as "below", "under", "lower", "beneath", "above", "upper" and the like may be used herein for ease of description to describe relationships between one element or feature and another element(s) or feature(s) as shown in the figures. It should be understood that the spatially relative terms may be intended to encompass different orientations of the device in use or operation in addition to the orientation depicted in the figures. For example, if the device in the figures is turned over, elements or features described as "under", "beneath" or "below" other elements would then be oriented "above" the other elements or features. Thus, the example term "under", "below" or "beneath" may encompass both an orientation of above and below. The device may be otherwise oriented (rotated 90 degrees or at other orientations) and the spatially relative descriptors used herein should be interpreted accordingly.

The terminology used herein is for the purpose of describing some embodiments only and is not intended to limit the present invention. As used herein, the singular forms of "a", "one" and "said/the" are also intended to include plural forms, unless the context clearly indicates otherwise. It should also be understood that the terms "comprising" and/or "including", when used in this specification, determine the presence of the described features, integers, steps, operations, elements and/or components, but do not preclude the presence or addition of one or more other features, integers, steps, operations, elements, components, and/or groups thereof. As used herein, the term "and/or" includes any and all combinations of related listed items.

Embodiments of the present invention are described herein with reference to cross-sectional illustrations serving as schematic illustrations of idealized embodiments (and intermediate structures) of the present invention. As such, variations from the shapes of the illustrations as a result, for example, of manufacturing techniques and/or tolerances, may be expected. However, embodiments of the present invention should not be construed as being limited to particular shapes of regions illustrated herein and may include deviations in shapes that result, for example, from manufacturing. Thus, regions illustrated in the figures are schematic in nature and their shapes do not necessarily illustrate the actual shape of a region of a device and do not intend to limit the scope of the present invention.

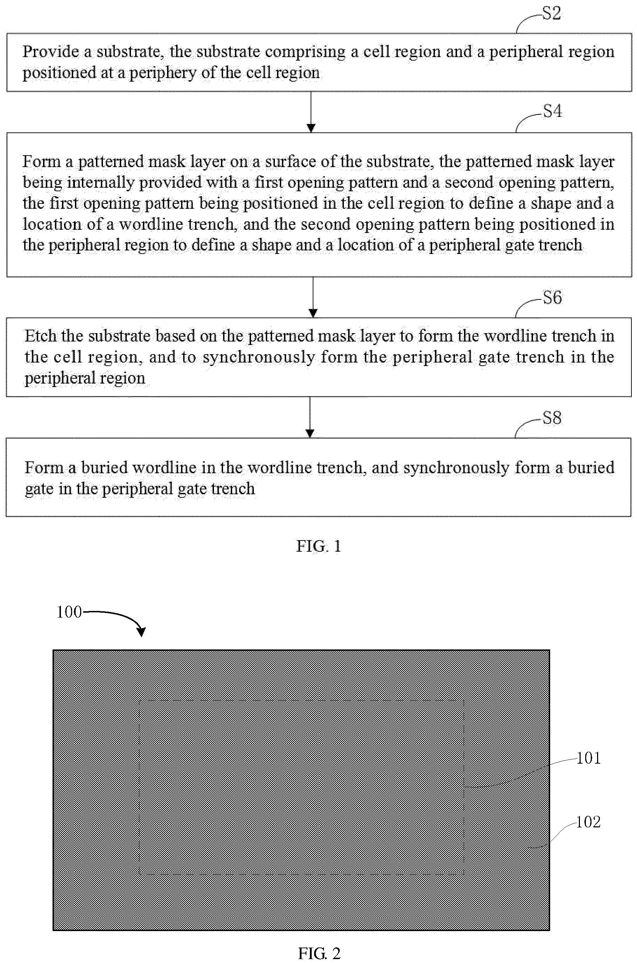

With reference to FIG. 1 to FIG. 5k, it should be noted that the illustrations provided in the embodiments merely illustrate the basic idea of the present invention in a schematic manner. Only the components related to the present invention are shown in the drawings rather than the number, shape and dimensional drawing of components in actual implementation. The form, number and proportion of each component in actual implementation may be random changed, and the component layout form may be more complicated.

With reference to FIG. 1, in one embodiment of the present invention, a method for manufacturing a semiconductor structure is provided, which includes following operations.

In operation S2, a substrate is provided. The substrate includes a cell region and a peripheral region positioned at a periphery of the cell region.

In operation S4, a patterned mask layer is formed on a surface of the substrate. The patterned mask layer is internally provided with a first opening pattern and a second opening pattern, the first opening pattern is positioned in the cell region to define a shape and a location of a word line trench, and the second opening pattern is positioned in the peripheral region to define a shape and a location of a peripheral gate trench.

In operation S6, the substrate is etched based on the patterned mask layer to form the word line trench in the cell region, and to synchronously form the peripheral gate trench in the peripheral region.

In operation S8, a buried word line is formed in the word line trench, and synchronously a buried gate is formed in the peripheral gate trench.

As an example, with continued reference to FIG. 1, a patterned mask layer is formed on a surface of a substrate including a cell region and a peripheral region positioned at a periphery of the cell region, and the patterned mask layer is internally provided with a first opening pattern and a second opening pattern. The first opening pattern is positioned in the cell region to define a shape and a location of a word line trench, and the second opening pattern is positioned in the peripheral region to define a shape and a location of a peripheral gate trench. The substrate is etched based on the patterned mask layer to form the word line trench in the cell region, and synchronously the peripheral gate trench is formed in the peripheral region. A buried word line is formed in the word line trench, and synchronously a buried gate is formed in the peripheral gate trench. In the present invention, a word line in the cell region and a gate in the peripheral region at the periphery of the cell region are subject to single exposure and manufactured synchronously, which reduces manufacturing costs compared with separately manufacturing the gate in the peripheral region where an additional photomask is required. In the present invention, the word line in the cell region and the gate in the peripheral region at the periphery of the cell region both have buried structures, such that it is ensured that the gate sizes of circuits in the peripheral region meet the requirements for circuit integration design while avoiding the increase of the short-channel effects and leakage current of the semiconductor devices.

In operation S 1, with reference to operation S2 in FIG. 1, FIG. 2 and FIG. 3, a substrate 100 is provided, and the substrate 100 includes a cell region 101 and a peripheral region 102 positioned at a periphery of the cell region 101. It is to be noted that FIG. 2 only schematically illustrates that the peripheral region 102 is positioned at the periphery of the cell region 101, which does not impose any limitation on embodiments of the present invention.

As an example, the substrate 100 may be formed of a semiconductor substrate such as a silicon wafer. The substrate 100 may include monocrystal silicon, polycrystalline silicon, or amorphous silicon. The substrate 100 may be selected from at least one of germanium (Ge), silicon germanium (SiGe), silicon carbide (SiC), gallium arsenide (GaAs), indium arsenide (InAs), or indium phosphide (InP). The substrate 100 may include a conductive region. Those skilled in the art may select a type of the substrate based on a type of a transistor formed on the substrate 100. Therefore, the type of the substrate 100 should not limit the scope of protection of the present invention.

The cell region 101 may be a high density region where a density of an active region of the cell region 101 is higher, and the peripheral region 102 may be a low density region where the density of the active region of the peripheral region 102 is lower.

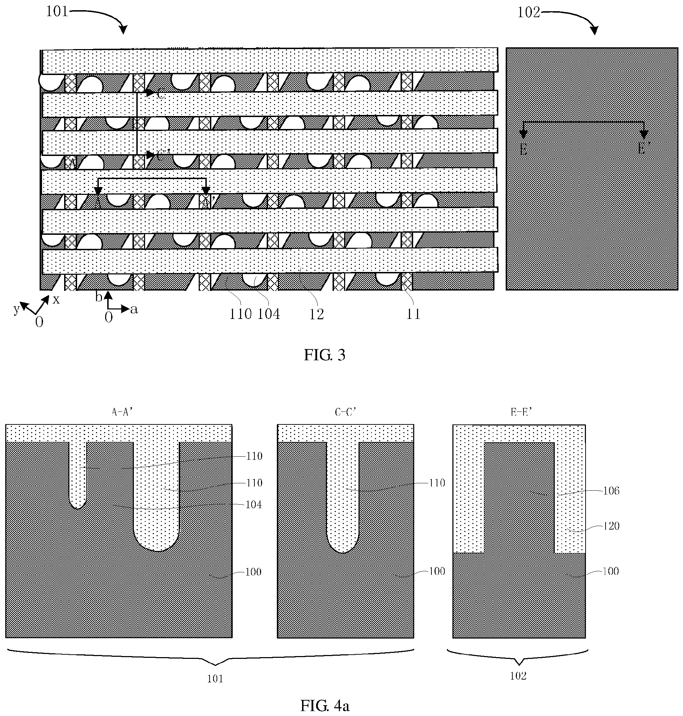

The cell region 101 may be a cell array region of a semiconductor memory device. As an example, a volatile memory cell array such as a dynamic random access memory (DRAM) may be formed in the cell region 101. In some embodiments, a nonvolatile memory cell array such as a flash memory may be formed in the cell region 101. A peripheral circuit electrically connected to a cell array formed in the cell region may be formed in the peripheral region 102. With reference to FIG. 2 and FIG. 3, a method of manufacturing a semiconductor structure according to an exemplary embodiment may include forming a first active region 104 and a first shallow trench isolation structure 110 in the cell region 101 of the substrate 100. The first shallow trench isolation structure 110 may confine the first active region 104. The first active region 104 may include an upper surface, a length of the upper surface in a first direction Ox is greater than a length of the upper surface in a second direction Oy, and the first direction Ox is perpendicular to the second direction Oy. It is to be noted that the first active region 104 has a long axis L in the first direction Ox and a short axis S in the second direction Oy. The first active region 104 may include a short sidewall S1 having a same width as the short axis S and a long sidewall L1 parallel to the long axis L. A plurality of first active regions 104 may be formed. The plurality of first active regions 104 may be spaced apart from each other by a first width P1 in the first direction Ox. In addition, the plurality of first active regions 104 may be spaced apart from each other by a second width P2 in the second direction Oy, the second width P2 being less than the first width P1. The plurality of first active regions 104 may be formed repeatedly and regularly in the first direction Ox and the second direction Oy. The first shallow trench isolation structure 110 may include a trench structure, and the trench structure may include a first insulating layer 112 and a second insulating layer 114 stacked sequentially from outside to inside. A bit line 11 may extend along a third direction Ob, and a word line 12 may extend along a fourth direction Oa.

In a semiconductor structure according to an exemplary embodiment, as shown in FIG. 4a, the peripheral region 102 of the substrate 100 has a second active region 106 and a second shallow trench isolation structure 120. The second shallow trench isolation structure 120 may confine the second active region 106. A plurality of second active regions 106 may be formed. The plurality of second active regions 106 may be spaced apart from each other by a third width P3, or the plurality of second active regions 106 may be spaced apart from each other by a fourth width P4. In an exemplary embodiment of the present invention, the second shallow trench isolation structure 120 may include an insulating layer liner (not shown) and a gap-filling insulating layer (not shown) stacked sequentially from outside to inside.

As an example, the operation S2 may include following operations.

In operation S22, a first mask layer (not shown) is formed on an upper surface of the substrate 100.

In operation S24, a first photoresist layer (not shown) is coated on the upper surface of the first mask layer (not shown), and the first photoresist layer is patterned to form a patterned photoresist layer (not shown).

In operation S26, the first mask layer is etched based on the patterned photoresist layer to form the patterned mask layer (not shown). The patterned mask layer (not shown) is internally provided with a first opening pattern and a second opening pattern, the first opening pattern is positioned in the cell region to define a shape and a location of a word line trench, and the second opening pattern is positioned in the peripheral region to define a shape and a location of a peripheral gate trench.

In operation S214, the patterned photoresist layer is removed.

As an example, the formed patterned mask layer may include a hard mask layer. The hard mask layer may have a single-layer structure or a multilayer stacked structure, and may be made from silicon oxide. Next, a photoresist is coated on the hard mask layer, and a patterned photoresist layer is formed through a series of processes such as exposure and development. The patterned photoresist layer defines the shape and the location of the word line trench, and defines the shape and the location of the peripheral gate trench. Next, the hard mask layer is etched based on the patterned photoresist layer to form a patterned mask layer, and then the patterned photoresist layer is removed. In other embodiments of the present invention, the patterned photoresist layer may also be remained in the process of forming the patterned mask layer, and the patterned photoresist layer is removed after the substrate 100 is etched.

As an example, in one embodiment of the present invention, the patterned mask layer is formed by means of a self-aligned double patterning technology (SADP). That is, after one photoetching process is completed, non-photoetching processing steps (such as thin film deposition, and etching, etc.) are employed in succession to implement spatial frequency multiplication of a photoetched pattern. Finally, excess patterns are removed by means of another photoetching and etching. Reference may be made to the issued patent "ACTIVE REGION ARRAY AND FORMING METHOD THEREOF, AND SEMICONDUCTOR DEVICE AND FORMING METHOD THEREOF" (CN110875313A) for a technology of how to form a patterned mask layer by means of SADP, detailed contents thereof are not to be repeated herein.

As an example, in one embodiment of the present invention, the patterned mask layer may be formed by means of a deep ultraviolet lithography technology. The patterned mask layer is formed by means of an extreme ultraviolet (EUV) lithography machine through the deep ultraviolet lithography technology. A buried word line pattern in the cell region and a buried gate pattern in the peripheral region at the periphery of the cell region are subject to single exposure and are synchronously fabricated to form a buried gate in the peripheral region, which reduces technological processes and device manufacturing costs. In this way, it is ensured that the gate sizes of circuits in the peripheral region meet the requirements for circuit integration design while avoiding the increase of the short-channel effects and leakage current of the semiconductor devices.

As an example, in one embodiment of the present invention, with reference to the operation S6 in FIG. 1 and FIGS. 4a to 4b, the operation S6 may include the following operations.

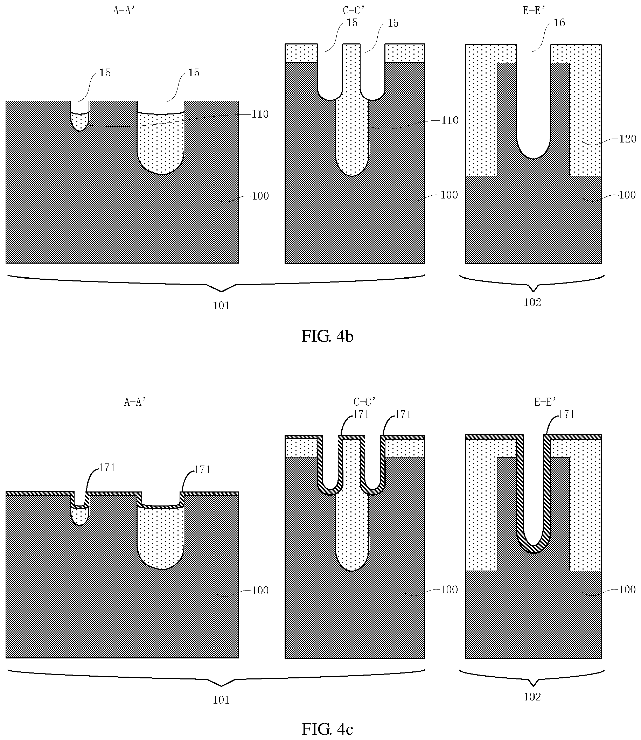

The upper surface of the substrate 100 is etched by means of a dry etch process or a wet etch process based on the patterned mask layer, to form a word line trench 15 in the cell region 101 and simultaneously form a peripheral gate trench 16 in the peripheral region 102, as shown in FIG. 4b.

As an example, in the operation S6, a plurality of word line trenches 15 regularly spaced apart from each other are synchronously formed, and a plurality of peripheral gate trenches 16 regularly spaced apart from each other are synchronously formed.

In the operation S8, with reference to the operation S8 in FIG. 1 and FIGS. 4c to 4i, forming a buried word line in the word line trench, and synchronously forming a buried gate in the peripheral gate trench includes following operations.

In operation S82, a gate oxide layer 17 is formed on an inner surface of the word line trench 15 and an inner surface of the peripheral gate trench 16.

In operation S84, a first work function layer 18 is formed on a surface of the gate oxide layer 17. The first work function layer 18 covers the gate oxide layer 17.

In operation S86, a first conductive layer 19 is formed on a surface of the first work function layer 18. The first conductive layer 19 is filled into the word line trench 15 without gaps, and a gap is provided in an inner side of the first conductive layer 19 positioned in the peripheral gate trench 16.

In operation S88, a primary conductive layer 20 is formed in the gap in the inner side of the first conductive layer 19.

In operation S810, the word line trench 15 and the peripheral gate trench 16 are filled in to form a cover insulation layer 30, such that the buried word line is formed in the word line trench and synchronously the buried gate is formed in the peripheral gate trench.

As an example, with continued reference to the operation S8 in FIG. 1 and FIG. 4c, in the operation S82, a gate oxide material layer 171 may be formed on the inner surface of the word line trench 15 and the inner surface of the peripheral gate trench 16 by means of at least one of an atomic layer deposition process, an in-situ steam generation process, or a rapid thermal oxidation process. For example, in this embodiment, the gate oxide material layer 171 may be formed on the inner surface of the word line trench 15 and the inner surface of the peripheral gate trench 16 by means of the in-situ steam generation process. The gate oxide material layer 171 overs the inner surface of the word line trench 15, the inner surface of the peripheral gate trench 16, and the upper surface of the substrate 100.

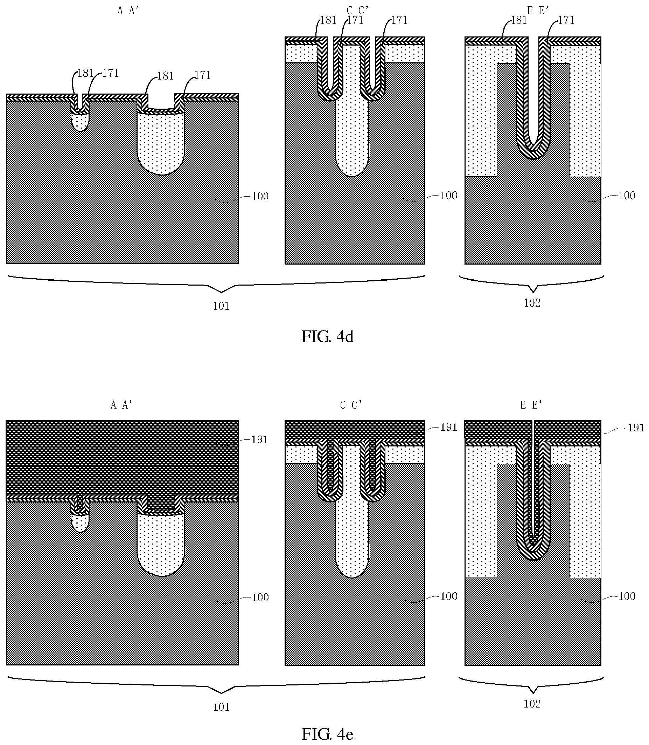

As an example, with continued reference to the operation S8 in FIG. 1 and FIG. 4d, in the operation S84, a first work function material layer 181 may be formed on a surface of the gate oxide material layer 171 by means of at least one of the atomic layer deposition process, the in-situ steam generation process, or the rapid thermal oxidation process. The first work function material layer 181 covers the gate oxide material layer 171. For example, in this embodiment, the first work function material layer 181 may be formed on the upper surface of the gate oxide material layer 171 by means of the atomic layer deposition process.

As an example, with continued reference to the operation S8 in FIG. 1 and FIG. 4e, a first conductive material layer 191 may be formed on the surface of the first work function material layer 181 by means of the deposition process in the operation S86. The first conductive material layer 191 is filled into the word line trench 15 without gaps, and a gap is provided in an inner side of the first conductive material layer 191 positioned in the peripheral gate trench 16.

As an example, with continued reference to FIG. 4e, the process for forming the first work function material layer 181 in the operation S86 may be at least one of a high density plasma (HDP) deposition process or a plasma enhanced deposition process. In the present invention, the first conductive material layer 191 may be formed on the surface of the first work function material layer 181 by means of the HDP deposition process. The first conductive material layer 191 is filled into the word line trench 15 without gaps, and a gap is provided in the inner side of the first conductive material layer 191 positioned in the peripheral gate trench 16.

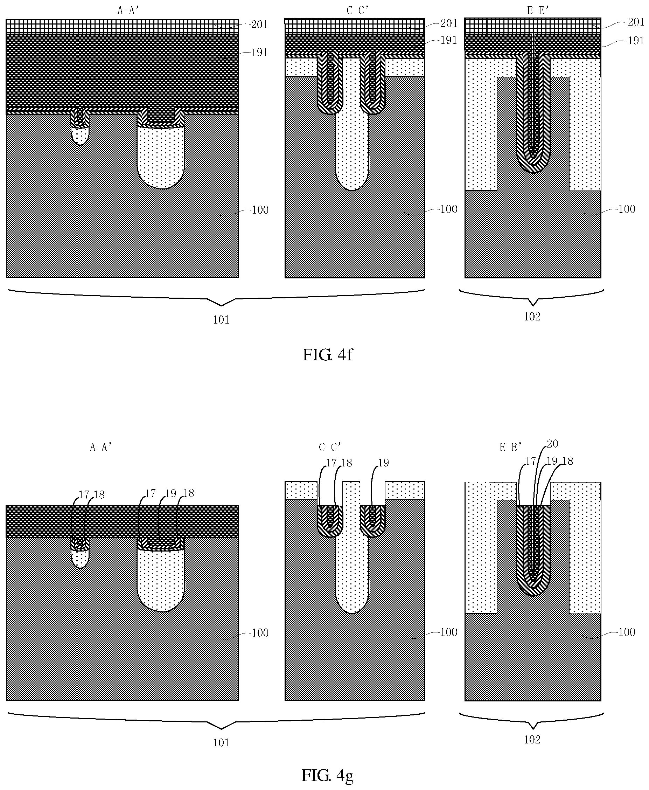

As an example, with continued reference to the operation S8 in FIG. 1 and FIG. 4f, a primary conductive material layer 201 may be filled into the gap in the inner side of the first conductive material layer 191 by means of a deposition process in the operation S88. For example, in the present invention, the primary conductive material layer 201 may be filled into the gap in the inner side of the first conductive material layer 191 by means of the HDP deposition process.

As an example, with continued reference to the operation S8 in FIG. 1 and FIG. 4g, after the operation of forming the primary conductive material layer 201, the method further includes following operations.

In operation S89, the obtained structure is etched back to remove the primary conductive material layer 201, the first conductive material layer 191, the first work function material layer 181 and the gate oxide material layer 171 above the substrate 100, and synchronously removing a part of the first conductive material layer 191, a part of the first work function material layer 181 and a part of the gate oxide material layer 171 in the word line trench 15, and removing a part of the primary conductive material layer 201, a part of the first conductive material layer 191, a part of the first work function material layer 181 and a part of the gate oxide material layer 171 in the peripheral gate trench 16. The first conductive material layer 191 remained in the word line trench 15 constitutes the first conductive layer 19, the first work function material layer 181 remained in the word line trench 15 constitutes the first work function layer 18, and the gate oxide material layer 171 remained in the word line trench 15 constitutes the gate oxide layer 17. The primary conductive material layer 201 remained in the peripheral gate trench 16 constitutes the primary conductive layer 20, the first conductive material layer 191 remained in the peripheral gate trench 16 constitutes the first conductive layer 19, the first work function material layer 181 remained in the peripheral gate trench 16 constitutes the first work function layer 18, and the gate oxide material layer 171 remained in the peripheral gate trench 16 constitutes the gate oxide layer 17. Top surfaces of the first conductive layer 19, the first work function layer 18 and the gate oxide layer 17 in the word line trench 15 are lower than a top surface of the word line trench 15. Top surfaces of the primary conductive layer 20, the first conductive layer 19, the first work function layer 18 and the gate oxide layer 17 in the peripheral gate trench 16 are lower than a top surface of the peripheral gate trench 16.

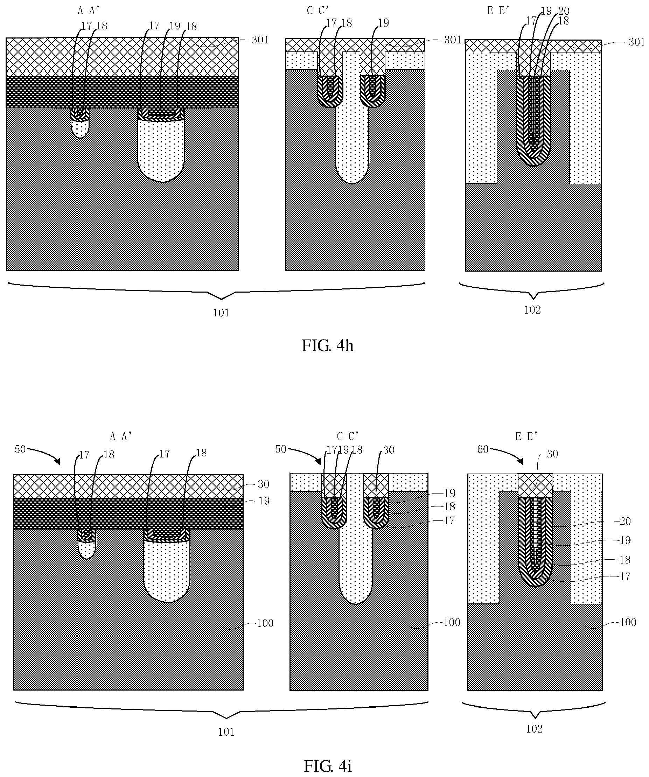

As an example, with continued reference to the operation S8 in FIG. 1 and FIG. 4h, the word line trench 15 and the peripheral gate trench 16 may be filled in respectively by means of the deposition process in the operation S810 to form a cover insulation material layer 301, such that the buried word line is formed in the word line trench and synchronously the buried gate is formed in the peripheral gate trench.

As an example, with continued reference to the operation S8 in FIG. 1 and FIG. 4i, in the operation S810, the cover insulation material layer 301 positioned on the upper surface of the substrate 100, the cover insulation material layer 301 positioned above the word line trench 15 and the cover insulation material layer 301 positioned above the peripheral gate trench 16 may be removed by means of a chemical mechanical polishing process, such that the upper surface of the substrate 100 is planarized. The cover insulation material layer 301 remained in the word line trench 15 and the cover insulation material layer 301 remained in the peripheral gate trench 16 constitute the cover insulation layer 30, such that the buried word line is formed in the word line trench 15 and synchronously the buried gate is formed in the peripheral gate trench 16.

In one embodiment of the present invention, forming the first work function layer 18 on the surface of the gate oxide layer 17 in the operation S84 includes following operations.

In operation S842, a hafnium silicate layer (not shown) is formed on the surface of the gate oxide material layer 171.

In operation S844, a lanthanum oxide layer (not shown) is formed on a surface of the hafnium silicate layer.

In operation S846, annealing treatment is performed on a structure obtained, such that lanthanum diffuses into the hafnium silicate layer to form a lanthanum-doped hafnium silicate layer.

As an example, in one embodiment of the present invention, after the lanthanum-doped hafnium silicate layer is formed, the method further includes: removing the lanthanum oxide layer.

In the method for manufacturing a semiconductor structure according to the above embodiment, the hafnium silicate layer is formed on the surface of the gate oxide layer, and the lanthanum oxide layer is formed on the surface of the hafnium silicate layer. Next, annealing treatment is performed on the structure obtained, such that lanthanum diffuses into the hafnium silicate layer to form the lanthanum-doped hafnium silicate layer. In this way, a gate having a higher dielectric constant is fabricated, and it is convenient to adjust a threshold value of the gate.

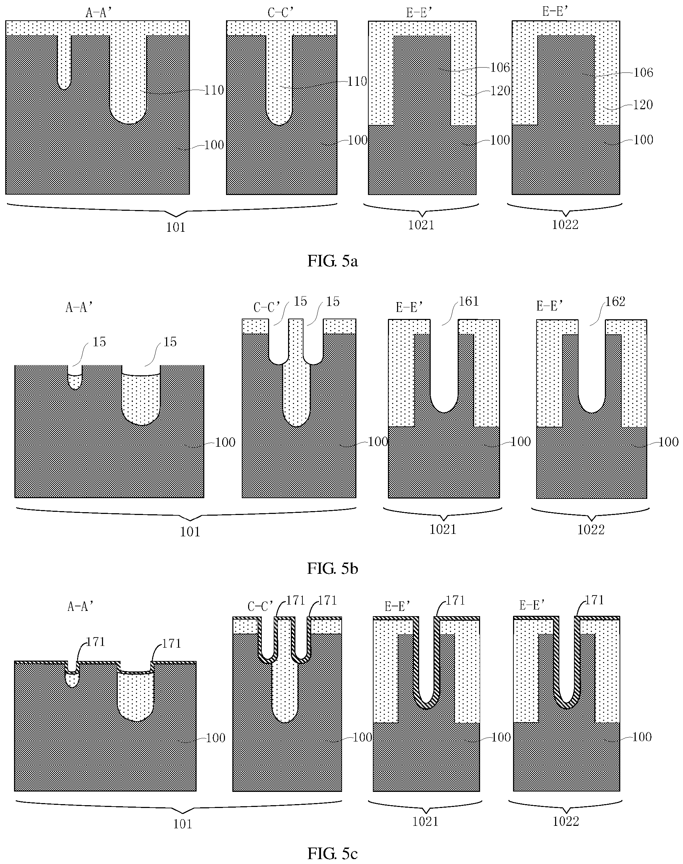

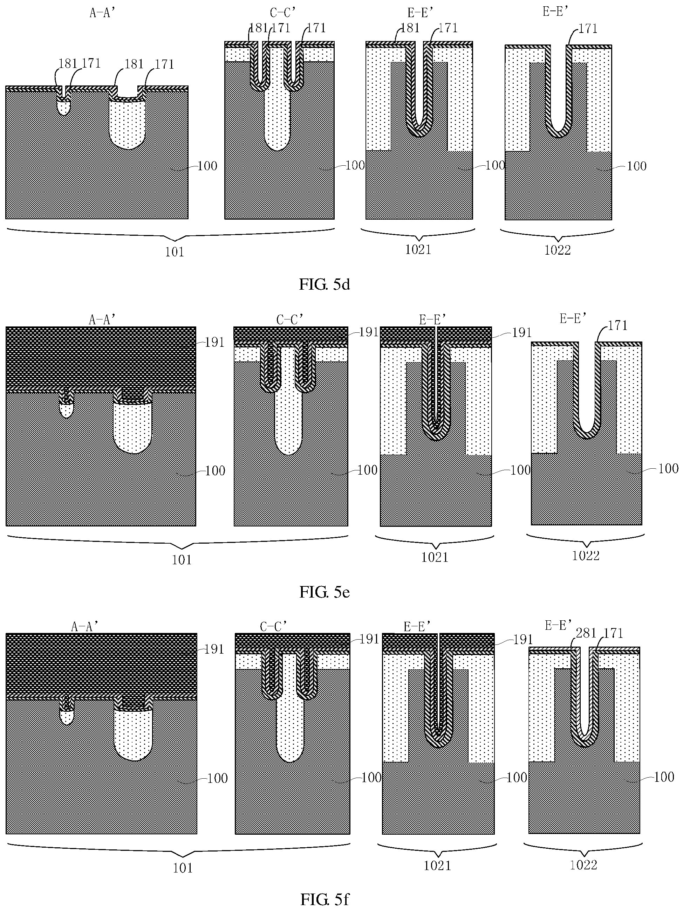

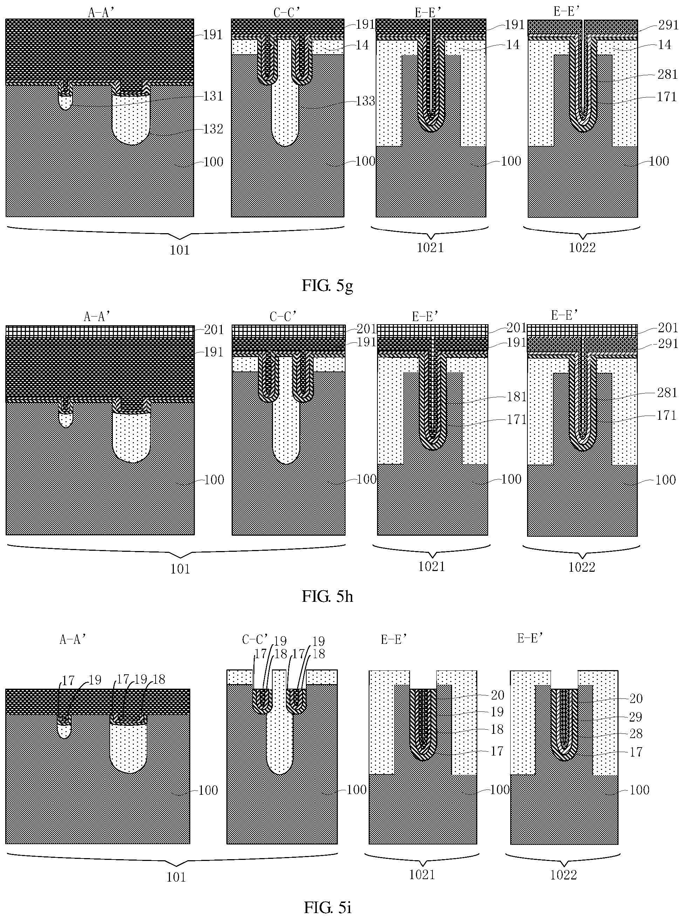

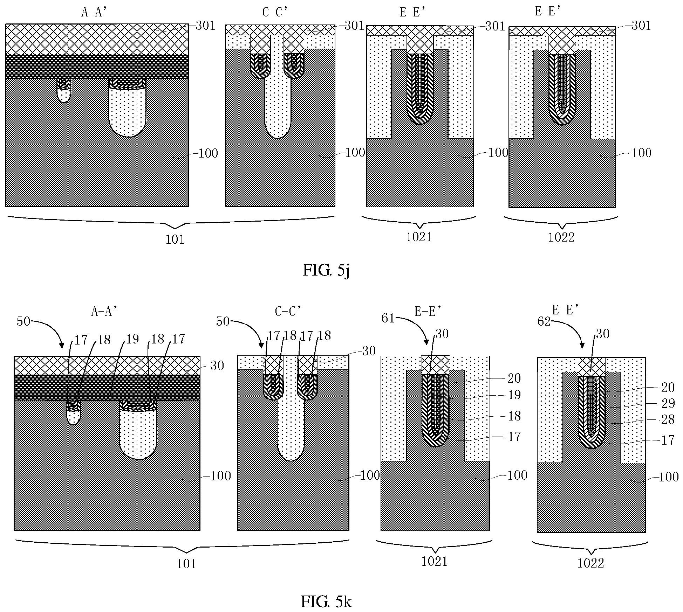

In another embodiment of the present invention, with reference to FIG. 5k, the peripheral gate trench 16 comprises a first peripheral gate trench 161 and a second peripheral gate trench 162. The formed buried gate comprising the gate oxide layer 17, the first work function layer 18, the first conductive layer 19, the primary conductive layer 20 and the cover insulation layer 30 is a first buried gate, and the first buried gate is positioned in the first peripheral gate trench 161. After the first conductive layer 19 is formed on the surface of the first work function layer 18, and before the primary conductive layer 20 is formed, the method further comprises: forming a second work function layer 28 on a surface of the gate oxide layer 17 in the second peripheral gate trench 162, and forming a second conductive layer 29 on a surface of the second work function layer 28, a gap being provided in an inner side of the second conductive layer 29. The primary conductive layer 20 is synchronously formed in the gap in the inner side of the first conductive layer 19 and in the gap in the inner side of the second conductive layer 29. The cover insulation layer 30 is synchronously formed in the word line trench 15, the first peripheral gate trench 161, and the second peripheral gate trench 162, to form a second buried gate in the second peripheral gate trench while the buried word line is formed in the word line trench 15 and the first buried gate is formed in the first peripheral gate trench 161.

As an example, with continued reference to the operation S6 in FIG. 1 and FIGS. 5a to 5b, the operation S6 may include the following operation.

The upper surface of the substrate 100 is etched by means of the dry etch process or the wet etch process based on the patterned mask layer, to form the word line trench 15 in the cell region 101 and simultaneously form the peripheral gate trench 16 in the peripheral region 102. The peripheral gate trench 16 includes a first peripheral gate trench 161 and a second peripheral gate trench 162.

As an example, in the operation S6, a plurality of word line trenches 15 regularly spaced apart from each other are synchronously formed, and a plurality of peripheral gate trenches 16 regularly spaced apart from each other are synchronously formed. The plurality of peripheral gate trenches 16 include a first peripheral gate trench 161 and a second peripheral gate trench 162.

In the operation S8, with reference to the operation S8 in FIG. 1 and FIG. 5k, forming a buried word line in the word line trench, and synchronously forming a buried gate in the peripheral gate trench includes following operations.

In operation S821, a gate oxide material layer 171 is formed on an inner surface of the word line trench 15, an inner surface of the first peripheral gate trench 161, and an inner surface of the second peripheral gate trench 162, respectively.

In operation S841, a first work function material layer 181 is formed on a surface of the gate oxide material layer 171. The first work function material layer 181 covers the gate oxide material layer 171.

In operation S861, a first conductive material layer 191 is formed on a surface of the first work function material layer 181 in the first peripheral gate trench 161. The first conductive material layer 191 is filled into the word line trench 15 without gaps, and a gap is provided in an inner side of the first conductive material layer 191 positioned in the first peripheral gate trench 161.

In operation S871, a second work function material layer 281 is formed on the surface of the gate oxide material layer 171 in the second peripheral gate trench 162. The second work function material layer 281 covers the surface of the gate oxide material layer 171 in the second peripheral gate trench 162.

In operation S872, a second conductive material layer 291 is formed on the surface of the second work function material layer 281 in the second peripheral gate trench 162. The second conductive material layer 291 covers the second work function material layer 281 in the second peripheral gate trench 162, and a gap is provided in an inner side of the second conductive material layer 291 in the second peripheral gate trench 162.

In operation S881, a primary conductive material layer 201 is formed in the gaps in the inner sides of the first conductive material layer 191 and the second conductive material layer 291.

In operation S891, the obtained structure is etched back to remove the primary conductive material layer 201, the first conductive material layer 191, the first work function material layer 181 and the gate oxide material layer 171 above the substrate 100, and synchronously removing a part of the first conductive material layer 191, a part of the first work function material layer 181 and a part of the gate oxide material layer 171 in the word line trench 15, removing a part of the primary conductive material layer 201, a part of the first conductive material layer 191, a part of the first work function material layer 181 and a part of the gate oxide material layer 171 in the first peripheral gate trench 161, and removing a part of the primary conductive material layer 201, a part of the second conductive material layer 291, a part of the second work function material layer 281 and a part of the gate oxide material layer 171 in the second peripheral gate trench 162. The first conductive material layer 191 remained in the word line trench 15 constitutes the first conductive layer 19, the first work function material layer 181 remained in the word line trench 15 constitutes the first work function layer 18, and the gate oxide material layer 171 remained in the word line trench 15 constitutes the gate oxide layer 17. The primary conductive material layer 201 remained in the first peripheral gate trench 161 constitutes the primary conductive layer 20, the first conductive material layer 191 remained in the first peripheral gate trench 161 constitutes the first conductive layer 19, the first work function material layer 181 remained in the first peripheral gate trench 161 constitutes the first work function layer 18, and the gate oxide material layer 171 remained in the first peripheral gate trench 161 constitutes the gate oxide layer 17. The primary conductive material layer 201 remained in the second peripheral gate trench 162 constitutes the primary conductive layer 20, the second conductive material layer 291 remained in the second peripheral gate trench 162 constitutes the second conductive layer 29, the second work function material layer 281 remained in the second peripheral gate trench 162 constitutes the second work function layer 28, and the gate oxide material layer 171 remained in the second peripheral gate trench 162 constitutes the gate oxide layer 17. Top surfaces of the first conductive layer 19, the first work function layer 18 and the gate oxide layer 17 in the word line trench 15 are lower than a top surface of the word line trench 15. Top surfaces of the primary conductive layer 20, the first conductive layer 19, the first work function layer 18 and the gate oxide layer 17 in the first peripheral gate trench 161 are lower than a top surface of the peripheral gate trench 161. Top surfaces of the primary conductive layer 20, the second conductive layer 29, the second work function layer 28 and the gate oxide layer 17 in the second peripheral gate trench 162 are lower than a top surface of the second peripheral gate trench 162.

In operation S811, the word line trench 15, the first peripheral gate trench 161 and the second peripheral gate trench 162 are filled in to form the cover insulation layer 30, such that the buried word line is formed in the word line trench and synchronously the buried gate is formed in the peripheral gate trench.

As an example, with continued reference to the operation S8 in FIG. 1 and FIGS. 5i-5k, the word line trench 15, the first peripheral gate trench 161 and the second peripheral gate trench 162 may be filled in respectively by means of the deposition process in the operation S811 to form a cover insulation material layer 301, such that the buried word line is formed in the word line trench and synchronously the buried gate is formed in the peripheral gate trench.

As an example, with continued reference to the operation S8 in FIG. 1 and FIGS. 5i-5k, the cover insulation material layer 301 positioned on the upper surface of the substrate 100, the cover insulation material layer 301 positioned above the word line trench 15, the cover insulation material layer 301 positioned above the first peripheral gate trench 161 and the cover insulation material layer 301 positioned above the second peripheral gate trench 162 may be removed by means of the chemical mechanical polishing process in the operation S811, such that the upper surface of the substrate 100 is planarized. The cover insulation material layer 301 remained in the word line trench 15, the cover insulation material layer 301 remained in the first peripheral gate trench 161 and the cover insulation material layer 301 remained in the second peripheral gate trench 162 constitute the cover insulation layer 30, to form the buried word line in the word line trench 15 and synchronously form the buried gate in the peripheral gate trench 16.

In one embodiment of the present invention, forming a second work function material layer 281 on a surface of the gate oxide material layer 171 in the second peripheral gate trench 162 in the operation S871 includes following operations.

In operation S8712, a hafnium silicate layer (not shown) is formed on the surface of the gate oxide material layer 171 in the second peripheral gate trench 162.

In operation S8714, an aluminum oxide layer (not shown) is formed on a surface of the hafnium silicate layer.

In operation S8716, annealing treatment is performed on a structure obtained, such that aluminum diffuses into the hafnium silicate layer to form an aluminum-doped hafnium silicate layer.

As an example, in one embodiment of the present invention, after the aluminum-doped hafnium silicate layer is formed, the method further includes: removing the aluminum oxide layer.

In the method for manufacturing a semiconductor structure according to the above embodiment, the hafnium silicate layer is formed on the surface of the gate oxide layer, and the aluminum oxide layer is formed on the surface of the hafnium silicate layer. Next, annealing treatment is performed on the structure obtained, such that aluminum diffuses into the hafnium silicate layer to form the aluminum-doped hafnium silicate layer. In this way, a gate having a higher dielectric constant is fabricated, and it is convenient to adjust a threshold value of the gate.

As an example, in one embodiment of the present invention, the gate oxide layer 17 may include, but is not limited to, a silicon oxide layer.

As an example, in one embodiment of the present invention, the cover insulation layer 30 may include, but is not limited to, a silicon nitride layer.

As an example, with reference to FIG. 4i, the semiconductor structure according to an exemplary embodiment includes a substrate 100 and a buried word line 50 and a buried gate 60 formed in the substrate 100. The substrate 100 includes a cell region 101 and a peripheral region 102 positioned at the periphery of the cell region 101. The buried word line 50 is positioned in the cell region 101, and the buried gate 60 is positioned in the peripheral region 102.

In some embodiments, with continued reference to FIG. 4i, the word line in the cell region 101 and the gate in the peripheral region 102 at the periphery of the cell region 101 both have buried structures, such that it is ensured that the gate sizes of circuits in the peripheral region 102 meet the requirements for circuit integration design while avoiding the increase of the short-channel effects and leakage current of the semiconductor devices.

With reference to FIG. 5k, in the semiconductor structure according to an exemplary embodiment, the buried gate includes a first buried gate 61 and a second buried gate 62. The first buried gate 61 is positioned in a first peripheral sub-region 1021, and the second buried gate 62 is positioned in a second peripheral sub-region 1022. The buried word line 50 includes a gate oxide layer 17, a first work function layer 18, a first conductive layer 19, and a cover insulation layer 30. In the buried word line 50, the gate oxide layer 17, the first work function layer 18 and the first conductive layer 19 are sequentially stacked from outside to inside. The cover insulation layer 30 is positioned on the upper surfaces of the gate oxide layer 17, the first work function layer 18 and the first conductive layer 19. The first buried gate 61 includes: the gate oxide layer 17, the first work function layer 18, the first conductive layer 19, a primary conductive layer 20, and the cover insulation layer 30. In the first buried gate 61, the gate oxide layer 17, the first work function layer 18, the first conductive layer 19 and the primary conductive layer 20 are sequentially stacked from the outside to the inside. The cover insulation layer 30 is positioned on the upper surfaces of the gate oxide layer 17, the first work function layer 18, the first conductive layer 19, and the primary conductive layer 20. The second buried gate 62 includes: the gate oxide layer 17, a second work function layer 28, a second conductive layer 29, the primary conductive layer 20, and the cover insulation layer 30. In the second buried gate 62, the gate oxide layer 17, the second work function layer 28, the second conductive layer 29 and the primary conductive layer 20 are sequentially stacked from the outside to the inside. The cover insulation layer 30 is positioned on the upper surfaces of the gate oxide layer 17, the second work function layer 28, the second conductive layer 29, and the primary conductive layer 20.

As an example, with continued reference to FIG. 5k, in one embodiment of the present invention, the first work function layer 18 includes a lanthanum-doped hafnium silicate layer, and the second work function layer 28 includes an aluminum-doped hafnium silicate layer. In this way, the dielectric constant of a gate of a semiconductor device is improved, and it is convenient to adjust the threshold value of the gate.

With continued reference to FIG. 5k, in one embodiment of the present invention, the first work function layer 18 further includes a lanthanum oxide layer (not shown), and the lanthanum oxide layer is positioned between the lanthanum-doped hafnium silicate layer (not shown) and the first conductive layer 19. The second work function layer 28 further includes an aluminum oxide layer (not shown), and the aluminum oxide layer is positioned between the aluminum-doped hafnium silicate layer (not shown) and the second conductive layer 29. In this way, the dielectric constant of the gate of the semiconductor device is improved, and it is convenient to adjust the threshold value of the gate.

As an example, with continued reference to FIG. 5k, in one embodiment of the present invention, the gate oxide layer 17 includes a silicon oxide layer.

As an example, with continued reference to FIG. 5k, in one embodiment of the present invention, the first conductive layer 19 and the second conductive layer 29 are both titanium nitride layers, and the primary conductive layer 20 is a tungsten layer.

As an example, with continued reference to FIG. 5k, in one embodiment of the present invention, the first conductive layer 19 and the second conductive layer 29 are both molybdenum nitride layers, and the primary conductive layer 20 is a molybdenum layer.

In conclusion, the present invention provides a method for manufacturing a semiconductor structure, and a semiconductor structure. A substrate is provided, where the substrate comprises a cell region and a peripheral region positioned at a periphery of the cell region. A patterned mask layer is formed on a surface of the substrate, where the patterned mask layer is internally provided with a first opening pattern and a second opening pattern. The first opening pattern is positioned in the cell region to define a shape and a location of a word line trench, and the second opening pattern is positioned in the peripheral region to define a shape and a location of a peripheral gate trench. Next, the substrate is etched based on the patterned mask layer to form the word line trench in the cell region, and synchronously the peripheral gate trench is formed in the peripheral region. Next, a buried word line is formed in the word line trench, and synchronously a buried gate is formed in the peripheral gate trench. In the present invention, a word line in the cell region and a gate in the peripheral region at the periphery of the cell region are subject to single exposure and manufactured synchronously, which reduces manufacturing costs compared with separately manufacturing the gate in the peripheral region where an additional photomask is required. In the present invention, the word line in the cell region and the gate in the peripheral region at the periphery of the cell region both have buried structures, such that it is ensured that the gate sizes of circuits in the peripheral region meet the requirements for circuit integration design while avoiding the increase of the short-channel effects and leakage current of the semiconductor devices.

It is to be noted that the above embodiments are intended for purposes of illustration only and are not intended to limit the present invention.

It should be understood that unless expressly stated herein, the execution of these operations is not strictly limited in sequence, and these operations may be performed in other orders. Moreover, at least some of the operations may include a plurality of sub-operations or a plurality of stages, which are not necessarily performed at the same moment, but may be executed at different moments, and the order of execution of these sub-operations or stages is not necessarily performed sequentially, but may be performed alternately or alternately with other operations or at least a portion of sub-operations or stages of other operations.

The embodiments in the specification are described in a progressive manner. Each embodiment is focused on difference from other embodiments. And cross reference is available for identical or similar parts among different embodiments.

For simplicity, all possible combinations of the technical features in the above embodiments are not described. However, as long as the combination of these technical features is not contradictory, it shall be deemed to be within the scope recited in this specification.

The above embodiments merely express a plurality of implementations of the present invention, and descriptions thereof are relatively concrete and detailed. However, these embodiments are not thus construed as limiting the patent scope of the present invention. It is to be pointed out that for persons of ordinary skill in the art, some modifications and improvements may be made. Thus, the scope of protection of the present invention shall be subject to the appended claims.

## Claims

1. A method for manufacturing a semiconductor structure, comprising:
providing (S2) a substrate (100), the substrate (100) comprising a cell region (101) and a peripheral region (102) positioned at a periphery of the cell region (101);
forming (S4) a patterned mask layer on a surface of the substrate (100), the patterned mask layer being internally provided with a first opening pattern and a second opening pattern, the first opening pattern being positioned in the cell region (101) to define a shape and a location of a word line trench (15), and the second opening pattern being positioned in the peripheral region (102) to define a shape and a location of a peripheral gate trench (16);
etching (S6) the substrate (100) based on the patterned mask layer to form the word line trench (15) in the cell region (101), and to synchronously form the peripheral gate trench (16) in the peripheral region (102), wherein the peripheral gate trench (16) comprises a first peripheral gate trench (161) and a second peripheral gate trench (162); and
forming (S8) a buried word line (50) in the word line trench (15), and synchronously forming a buried gate (60) in the peripheral gate trench (16), comprising:
forming a gate oxide layer (17) on an inner surface of the word line trench (15), an inner surface of the first peripheral gate trench (161) and an inner surface of the second peripheral gate trench (162);
forming a first work function layer (18) on a surface of the gate oxide layer (17) in the word line trench (15) and the first peripheral gate trench (161), the first work function layer (18) covering the gate oxide layer (17) in the word line trench (15) and the first peripheral gate trench (161), comprising:
forming a hafnium silicate layer on the surface of the gate oxide layer (17) in the word line trench (15) and the first peripheral gate trench (161);
forming a lanthanum oxide layer on a surface of the hafnium silicate layer in the word line trench (15) and the first peripheral gate trench (161); and
performing annealing treatment on a structure obtained, such that lanthanum diffuses into the hafnium silicate layer to form a lanthanum-doped hafnium silicate layer;
forming a first conductive layer (19) on a surface of the first work function layer (18), the first conductive layer (19) being filled into the word line trench (15) without gaps, and a gap being provided in an inner side of the first conductive layer (19) positioned in the first peripheral gate trench (161);
forming a second work function layer (28) on a surface of the gate oxide layer (17) in the second peripheral gate trench (162), comprising:
forming a hafnium silicate layer on the surface of the gate oxide layer (17) in the second peripheral gate trench (162);
forming an aluminum oxide layer on a surface of the hafnium silicate layer in the second peripheral gate trench (162); and
performing annealing treatment on a structure obtained, such that aluminum diffuses into the hafnium silicate layer to form an aluminum-doped hafnium silicate layer;
forming a second conductive layer (29) on a surface of the second work function layer (28), a gap being provided in an inner side of the second conductive layer (29);
synchronously forming a primary conductive layer (20) in the gap in the inner side of the first conductive layer (19) and in the gap in the inner side of the second conductive layer (29); and
filling in the word line trench (15), the first peripheral gate trench (161) and the second peripheral gate trench (162) to form a cover insulation layer (30), such that the buried word line (50) is formed in the word line trench (15) and synchronously a first buried gate (61) is formed in the first peripheral gate trench (161) and a second buried gate (62) is formed in the second peripheral gate trench (162).

2. The method for manufacturing a semiconductor structure according to claim 1, wherein the patterned mask layer is formed by means of a self-aligned double patterning technology or a deep ultraviolet lithography technology.

3. The method for manufacturing a semiconductor structure according to claim 1, wherein the gate oxide layer (17) is formed by means of an in-situ steam generation process.

4. A semiconductor structure, comprising:
a substrate (100), the substrate (100) comprising a cell region (101) and a peripheral region (102) positioned at a periphery of the cell region (101);
a buried word line (50) positioned in the cell region (101); and
a buried gate (60) positioned in the peripheral region (102), wherein the buried gate (60) comprises a first buried gate (61) and a second buried gate (62); and the buried word line (50) comprises a gate oxide layer (17), a first work function layer (18), a first conductive layer (19), and a cover insulation layer (30);
the gate oxide layer (17), the first work function layer (18) and the first conductive layer (19) are stacked in sequence from outside to inside in the buried word line (50), the cover insulation layer (30) being positioned on upper surfaces of the gate oxide layer (17), of the first work function layer (18), and of the first conductive layer (19);
the first buried gate (61) comprises: the gate oxide layer (17), the first work function layer (18), the first conductive layer (19), a primary conductive layer (20), and the cover insulation layer (30);
the gate oxide layer (17), the first work function layer (18), the first conductive layer (19) and the primary conductive layer (20) are stacked in sequence from outside to inside in the first buried gate (61), the cover insulation layer (30) being positioned on upper surfaces of the gate oxide layer (17), of the first work function layer (18), of the first conductive layer (19), and of the primary conductive layer (20);
the second buried gate (62) comprises: the gate oxide layer (17), a second work function layer (28), a second conductive layer (29), the primary conductive layer (20), and the cover insulation layer (30); and
the gate oxide layer (17), the second work function layer (28), the second conductive layer (29) and the primary conductive layer (20) are stacked in sequence from outside to inside in the second buried gate (62), the cover insulation layer (30) being positioned on upper surfaces of the gate oxide layer (17), of the second work function layer (28), of the second conductive layer (29), and of the primary conductive layer (20),
wherein the first work function layer (18) comprises a lanthanum-doped hafnium silicate layer and a lanthanum oxide layer positioned between the lanthanum-doped hafnium silicate layer and the first conductive layer, and the second work function layer (28) comprises an aluminum-doped hafnium silicate layer and an aluminum oxide layer positioned between the aluminum-doped hafnium silicate layer and the second conductive layer.

5. The semiconductor structure according to claim 4, wherein the gate oxide layer (17) comprises a silicon oxide layer.

6. The semiconductor structure according to claim 4, wherein the first conductive layer (19) and the second conductive layer (29) are both titanium nitride layers, and the primary conductive layer (20) is a tungsten layer; or
the first conductive layer (19) and the second conductive layer (29) are both molybdenum nitride layers, and the primary conductive layer (20) is a molybdenum layer.

## Patentansprüche

1. Verfahren zum Herstellen einer Halbleiterstruktur, umfassend:
Bereitstellen (S2) eines Substrats (100), das Substrat (100) umfassend einen Zellbereich (101) und einen peripheren Bereich (102), der an einer Peripherie des Zellbereichs (101) angeordnet ist;
Bilden (S4) einer gemusterten Maskenschicht auf einer Oberfläche des Substrats (100), wobei die gemusterte Maskenschicht im Inneren mit einem ersten Öffnungsmuster und einem zweiten Öffnungsmuster versehen ist, wobei das erste Öffnungsmuster in dem Zellbereich (101) positioniert ist, um eine Form und eine Stelle eines Wortzeilengrabens (15) zu definieren, und das zweite Öffnungsmuster in dem peripheren Bereich (102) positioniert ist, um eine Form und eine Stelle eines peripheren Gate-Grabens (16) zu definieren;
Ätzen (S6) des Substrats (100) basierend auf der gemusterten Maskenschicht, um den Wortzeilengraben (15) in dem Zellbereich (101) zu bilden, und um synchron den peripheren Gate-Graben (16) in dem peripheren Bereich (102) zu bilden, wobei der periphere Gate-Graben (16) einen ersten peripheren Gate-Graben (161) und einen zweiten peripheren Gate-Graben (162) umfasst; und
Bilden (S8) einer vergrabenen Wortzeile (50) in dem Wortzeilengraben (15) und synchrones Bilden eines vergrabenen Gates (60) in dem peripheren Gate-Graben (16), umfassend:
Bilden einer Gate-Oxidschicht (17) auf einer inneren Oberfläche des Wortzeilengrabens (15), einer inneren Oberfläche des ersten peripheren Gate-Grabens (161) und einer inneren Oberfläche des zweiten peripheren Gate-Grabens (162);
Bilden einer ersten Arbeitsfunktionsschicht (18) auf einer Oberfläche der Gate-Oxidschicht (17) in dem Wortzeilengraben (15) und dem ersten peripheren Gate-Graben (161), wobei die erste Arbeitsfunktionsschicht (18) die Gate-Oxidschicht (17) in dem Wortzeilengraben (15) und dem ersten peripheren Gate-Graben (161) bedeckt, umfassend:
Bilden einer Hafniumsilikatschicht auf der Oberfläche der Gate-Oxidschicht (17) in dem Wortzeilengraben (15) und in dem ersten peripheren Gate-Graben (161);
Bilden einer Lanthanoxidschicht auf einer Oberfläche der Hafniumsilikatschicht in dem Wortzeilengraben (15) und dem ersten peripheren Gate-Graben (161); und
Ausführen einer Glühbehandlung an einer erlangten Struktur, sodass Lanthan in die Hafniumsilikatschicht diffundiert, um eine lanthandotierte Hafniumsilikatschicht zu bilden;
Bilden einer ersten leitenden Schicht (19) auf einer Oberfläche der ersten Arbeitsfunktionsschicht (18), wobei die erste leitende Schicht (19) lückenlos in den Wortzeilengraben (15) gefüllt wird und eine Lücke in einer Innenseite der ersten leitenden Schicht (19) bereitgestellt ist, die in dem ersten peripheren Gate-Graben (161) positioniert ist;
Bilden einer zweiten Arbeitsfunktionsschicht (28) auf einer Oberfläche der Gate-Oxidschicht (17) in dem zweiten peripheren Gate-Graben (162), umfassend:
Bilden einer Hafniumsilikatschicht auf der Oberfläche der Gate-Oxidschicht (17) in dem zweiten peripheren Gate-Graben (162);
Bilden einer Aluminiumoxidschicht auf einer Oberfläche der Hafniumsilikatschicht in dem zweiten peripheren Gate-Graben (162); und
Ausführen einer Glühbehandlung an einer erlangten Struktur, sodass Aluminium in die Hafniumsilikatschicht diffundiert und eine aluminiumdotierte Hafniumsilikatschicht bildet;
Bilden einer zweiten leitenden Schicht (29) auf einer Oberfläche der zweiten Arbeitsfunktionsschicht (28), wobei ein Spalt in einer Innenseite der zweiten leitenden Schicht (29) bereitgestellt ist;
synchrones Bilden einer primären leitenden Schicht (20) in dem Spalt auf der Innenseite der ersten leitenden Schicht (19) und in dem Spalt auf der Innenseite der zweiten leitenden Schicht (29); und
Füllen des Wortzeilengrabens (15), des ersten peripheren Gate-Grabens (161) und des zweiten peripheren Gate-Grabens (162), um eine Abdeckisolierschicht (30) zu bilden, sodass die vergrabene Wortzeile (50) in dem Wortzeilengraben (15) gebildet wird und gleichzeitig ein erstes vergrabenes Gate (61) in dem ersten peripheren Gate-Graben (161) gebildet wird und ein zweites vergrabenes Gate (62) in dem zweiten peripheren Gate-Graben (162) gebildet wird.

2. Verfahren zum Herstellen einer Halbleiterstruktur nach Anspruch 1, wobei die strukturierte Maskenschicht mittels einer selbstausrichtenden Doppelstrukturierungstechnologie oder einer Tief-Ultraviolett-Lithographietechnologie gebildet wird.

3. Verfahren zum Herstellen einer Halbleiterstruktur nach Anspruch 1, wobei die Gate-Oxidschicht (17) mittels eines in-situ-Dampferzeugungsprozesses gebildet wird.

4. Halbleiterstruktur, umfassend:
ein Substrat (100), das Substrat (100) umfassend einen Zellbereich (101) und einen peripheren Bereich (102), der an einer Peripherie des Zellbereichs (101) angeordnet ist;
eine vergrabene Wortzeile (50), die in der Zellregion (101) positioniert ist; und
ein vergrabenes Gate (60), das in dem peripheren Bereich (102) positioniert ist, wobei das vergrabene Gate (60) ein erstes vergrabenes Gate (61) und ein zweites vergrabenes Gate (62) umfasst; und die vergrabene Wortzeile (50) eine Gate-Oxidschicht (17), eine erste Arbeitsfunktionsschicht (18), eine erste leitende Schicht (19) und eine Deckisolationsschicht (30) umfasst;
wobei die Gate-Oxidschicht (17), die erste Arbeitsfunktionsschicht (18) und die erste leitende Schicht (19) in der vergrabenen Wortzeile (50) von außen nach innen aufeinandergestapelt sind, wobei die Deckisolationsschicht (30) auf den oberen Oberflächen der Gate-Oxidschicht (17), der ersten Arbeitsfunktionsschicht (18) und der ersten leitenden Schicht (19) angeordnet ist;
wobei das erste vergrabene Gate (61) Folgendes umfasst: die Gate-Oxidschicht (17), die erste Arbeitsfunktionsschicht (18), die erste leitende Schicht (19), eine primäre leitende Schicht (20) und die Deckisolationsschicht (30);
wobei die Gate-Oxidschicht (17), die erste Arbeitsfunktionsschicht (18), die erste leitende Schicht (19) und die primäre leitende Schicht (20) in dem ersten vergrabenen Gate (61) nacheinander von außen nach innen gestapelt sind, wobei die Deckisolationsschicht (30) auf oberen Oberflächen der Gate-Oxidschicht (17), der ersten Arbeitsfunktionsschicht (18), der ersten leitenden Schicht (19) und der primären leitenden Schicht (20) angeordnet ist;
wobei das zweite vergrabene Gate (62) Folgendes umfasst: die Gate-Oxidschicht (17), eine zweite Arbeitsfunktionsschicht (28), eine zweite leitende Schicht (29), die primäre leitende Schicht (20) und die Deckisolationsschicht (30); und
wobei die Gate-Oxidschicht (17), die zweite Arbeitsfunktionsschicht (28), die zweite leitende Schicht (29) und die primäre leitende Schicht (20) in dem zweiten vergrabenen Gate (62) in der Reihenfolge von außen nach innen gestapelt sind, wobei die Deckisolationsschicht (30) auf oberen Oberflächen der Gate-Oxidschicht (17), der zweiten Arbeitsfunktionsschicht (28), der zweiten leitenden Schicht (29) und der primären leitenden Schicht (20) angeordnet ist,
wobei die erste Arbeitsfunktionsschicht (18) eine mit Lanthan dotierte Hafniumsilicatschicht und eine zwischen der mit Lanthan dotierten Hafniumsilicatschicht und der ersten leitenden Schicht angeordnete Lanthanoxidschicht umfasst, und die zweite Arbeitsfunktionsschicht (28) eine mit Aluminium dotierte Hafniumsilicatschicht und eine zwischen der mit Aluminium dotierten Hafniumsilicatschicht und der zweiten leitenden Schicht angeordnete Aluminiumoxidschicht umfasst.

5. Halbleiterstruktur nach Anspruch 4, wobei die Gate-Oxidschicht (17) eine Siliziumoxidschicht umfasst.

6. Halbleiterstruktur nach Anspruch 4, wobei die erste leitende Schicht (19) und die zweite leitende Schicht (29) beide Titannitridschichten sind und die primäre leitende Schicht (20) eine Wolframschicht ist; oder
die erste leitende Schicht (19) und die zweite leitende Schicht (29) beide Molybdännitridschichten, sind und die primäre leitende Schicht (20) eine Molybdänschicht ist.

## Revendications

1. Procédé de fabrication d'une structure semi-conductrice, comprenant :
la fourniture (S2) d'un substrat (100), le substrat (100) comprenant une région cellulaire (101) et une région périphérique (102) positionnée à une périphérie de la région cellulaire (101) ;
la formation (S4) d'une couche de masque à motifs sur une surface du substrat (100), la couche de masque à motifs étant pourvue intérieurement d'un premier motif d'ouverture et d'un second motif d'ouverture, le premier motif d'ouverture étant positionné dans la région cellulaire (101) pour définir une forme et un emplacement d'une tranchée de ligne de mot (15), et le second motif d'ouverture étant positionné dans la région périphérique (102) pour définir une forme et un emplacement d'une tranchée de grille périphérique (16) ;
la gravure (S6) du substrat (100) sur la base de la couche de masque à motifs pour former la tranchée de ligne de mots (15) dans la région cellulaire (101) et pour former de manière synchrone la tranchée de grille périphérique (16) dans la région périphérique (102), dans lequel la tranchée de grille périphérique (16) comprend une première tranchée de grille périphérique (161) et une seconde tranchée de grille périphérique (162) ; et
la formation (S8) d'une ligne de mot enterrée (50) dans la tranchée de ligne de mot (15), et former de manière synchrone une grille enterrée (60) dans la tranchée de grille périphérique (16), comprenant :
la formation d'une couche d'oxyde de grille (17) sur une surface intérieure de la tranchée de la ligne de mots (15), une surface intérieure de la première tranchée de grille périphérique (161) et une surface intérieure de la seconde tranchée de grille périphérique (162) ;
la formation d'une première couche de fonction de travail (18) sur une surface de la couche d'oxyde de grille (17) dans la tranchée de ligne de mots (15) et la première tranchée de grille périphérique (161), la première couche de fonction de travail (18) recouvrant la couche d'oxyde de grille (17) dans la tranchée de ligne de mots (15) et la première tranchée de grille périphérique (161), comprenant :
la formation d'une couche de silicate d'hafnium sur la surface de la couche d'oxyde de grille (17) dans la tranchée de ligne de mots (15) et la première tranchée de grille périphérique (161) ;
la formation d'une couche d'oxyde de lanthane sur une surface de la couche de silicate d'hafnium dans la tranchée de ligne de mots (15) et la première tranchée de grille périphérique (161) ; et
la réalisation d'un traitement de recuit sur une structure obtenue, de sorte que le lanthane se diffuse dans la couche de silicate d'hafnium pour former une couche de silicate d'hafnium dopée au lanthane ;
la formation d'une première couche conductrice (19) sur une surface de la première couche de fonction de travail (18), la première couche conductrice (19) étant remplie dans la tranchée de ligne de mots (15) sans espace, et un espace étant prévu dans un côté intérieur de la première couche conductrice (19) positionnée dans la première tranchée de grille périphérique (161) ;
la formation d'une seconde couche de fonction de travail (28) sur une surface de la couche d'oxyde de grille (17) dans la seconde tranchée de grille périphérique (162), comprenant :
la formation d'une couche de silicate d'hafnium sur la surface de la couche d'oxyde de grille (17) dans la seconde tranchée de grille périphérique (162) ;
la formation d'une couche d'oxyde d'aluminium sur une surface de la couche de silicate d'hafnium dans la seconde tranchée de grille périphérique (162) ; et
la réalisation d'un traitement de recuit sur une structure obtenue, de sorte que l'aluminium se diffuse dans la couche de silicate d'hafnium pour former une couche de silicate d'hafnium dopée à l'aluminium ;
la formation d'une seconde couche conductrice (29) sur une surface de la seconde couche de fonction de travail (28), un espace étant prévu sur une face interne de la seconde couche conductrice (29) ;
la formation de manière synchronisée une couche conductrice primaire (20) dans l'espace de la face interne de la première couche conductrice (19) et dans l'espace de la face interne de la seconde couche conductrice (29) ; et
le remplissage de la tranchée de la ligne de mots (15), de la première tranchée de la porte périphérique (161) et de la seconde tranchée de la porte périphérique (162) pour former une couche d'isolation de couverture (30), de sorte que la ligne de mots enterrée (50) est formée dans la tranchée de la ligne de mots (15) et que, de manière synchronisée, une première grille enterrée (61) est formée dans la première tranchée de grille périphérique (161) et une seconde grille enterrée (62) est formée dans la seconde tranchée de grille périphérique (162).

2. Procédé de fabrication d'une structure semi-conductrice selon la revendication 1, dans lequel la couche de masque à motifs est formée au moyen d'une technologie de double structuration auto-alignée ou d'une technologie de lithographie à rayons ultraviolets profonds.

3. Procédé de fabrication d'une structure semi-conductrice selon la revendication 1, dans lequel la couche d'oxyde de grille (17) est formée au moyen d'un processus de génération de vapeur in situ.

4. Structure semi-conductrice, comprenant :
un substrat (100), le substrat (100) comprenant une région cellulaire (101) et une région périphérique (102) positionnée à une périphérie de la région cellulaire (101) ;
une ligne de mots enterrés (50) positionnée dans la région cellulaire (101) ; et
une grille enterrée (60) positionnée dans la région périphérique (102), dans laquelle la grille enterrée (60) comprend une première grille enterrée (61) et une seconde grille enterrée (62) ; et la ligne de mots enterrée (50) comprend une couche d'oxyde de grille (17), une première couche de fonction de travail (18), une première couche conductrice (19), et une couche d'isolation de couverture (30) ;
la couche d'oxyde de grille (17), la première couche de fonction de travail (18) et la première couche conductrice (19) sont empilées dans l'ordre, de l'extérieur vers l'intérieur dans la ligne de mots enterrée (50), la couche d'isolation de couverture (30) étant positionnée sur les surfaces supérieures de la couche d'oxyde de grille (17), de la première couche de travail (18) et de la première couche conductrice (19) ;
la première grille enterrée (61) comprend : la couche d'oxyde de grille (17), la première couche de travail (18), la première couche conductrice (19), une couche conductrice primaire (20) et la couche d'isolation de couverture (30) ;
la couche d'oxyde de grille (17), la première couche de fonction de travail (18), la première couche conductrice (19) et la couche conductrice primaire (20) sont empilées dans l'ordre, de l'extérieur vers l'intérieur, dans la première grille enterrée (61), la couche isolante de couverture (30) étant positionnée sur les surfaces supérieures de la couche d'oxyde de grille (17), de la première couche de fonction de travail (18), de la première couche conductrice (19) et de la couche conductrice primaire (20) ;
la seconde grille enterrée (62) comprend : la couche d'oxyde de grille (17), une seconde couche de fonction de travail (28), une seconde couche conductrice (29), la couche conductrice primaire (20) et la couche d'isolation de couverture (30) ; et
la couche d'oxyde de grille (17), la seconde couche de fonction de travail (28), la seconde couche conductrice (29) et la couche conductrice primaire (20) sont empilées dans l'ordre, de l'extérieur vers l'intérieur, dans la seconde grille enterrée (62), la couche isolante de couverture (30) étant positionnée sur les surfaces supérieures de la couche d'oxyde de grille (17), de la seconde couche de fonction de travail (28), de la seconde couche conductrice (29) et de la couche conductrice primaire (20) ;
dans laquelle la première couche de fonction de travail (18) comprend une couche de silicate de hafnium dopée au lanthane et une couche d'oxyde de lanthane placée entre la couche de silicate de hafnium dopée au lanthane et la première couche conductrice, et la seconde couche de fonction de travail (28) comprend une couche de silicate de hafnium dopée à l'aluminium et une couche d'oxyde d'aluminium placée entre la couche de silicate de hafnium dopée à l'aluminium et la seconde couche conductrice.

5. Structure semi-conductrice selon la revendication 4, dans laquelle la couche d'oxyde de grille (17) comprend une couche d'oxyde de silicium.

6. Structure semi-conductrice selon la revendication 4, dans laquelle la première couche conductrice (19) et la seconde couche conductrice (29) sont toutes deux des couches de nitrure de titane, et la couche conductrice primaire (20) est une couche de tungstène ; ou
la première couche conductrice (19) et la seconde couche conductrice (29) sont toutes deux des couches de nitrure de molybdène, et la couche conductrice primaire (20) est une couche de molybdène.
